# EUROPEAN PATENT APPLICATION

(11) **EP 4 633 346 A1**
(43) Date of publication of application: **15.10.2025**
(21) Application number: 23900443.5
(22) Date of filing: 21.11.2023
(51) Int. Cl.: H10N 10/817, C22C 23/00, C22F 1/06, H10N 10/01, H10N 10/852

(54) **THERMOELECTRIC CONVERSION ELEMENT, THERMOELECTRIC CONVERSION MODULE, THERMOELECTRIC CONVERSION SYSTEM, ELECTRIC POWER GENERATION METHOD, AND METHOD FOR PRODUCING THERMOELECTRIC CONVERSION ELEMENT**

(30) Priority: 08.12.2022 JP 2022196646
(71) Applicant: Panasonic Intellectual Property Management Co., Ltd., Kadoma-shi, Osaka 571-0057 (JP)
(72) Inventor: KAWABE, Takeshi, Kadoma-shi, Osaka 571-0057 (JP); TAMAKI, Hiromasa, Kadoma-shi, Osaka 571-0057 (JP)
(74) Representative: Grünecker Patent- und Rechtsanwälte PartG mbB
(86) International application number: PCT/JP2023/041704
(87) International publication number: WO 2024/122324

(57) **Abstract**

The present disclosure provides a thermoelectric conversion element that is advantageous in terms of decreasing an electrical resistance of thermoelectric conversion elements. According to the present disclosure, a thermoelectric conversion element 10a includes a first metal layer 12a, a second metal layer 12b, and a thermoelectric conversion layer 11. The thermoelectric conversion layer 11 is disposed between the first metal layer 12a and the second metal layer 12b in a thickness direction of the first metal layer 12a. The thermoelectric conversion layer 11 includes a thermoelectric conversion material containing Mg. The first metal layer 12a includes a first region 12j and a second region 12k. The first region 12j contains oxygen atoms. The second region 12k is different from the first region 12j. The first region 12j is disposed within an interior of the first metal layer 12a. An atomic content of the oxygen atoms in the first region 12j is higher than an atomic content of oxygen atoms in the second region 12k of the first metal layer 12a. In addition, the atomic content of the oxygen atoms in the first region 12j is higher than an atomic content of oxygen atoms in the thermoelectric conversion layer 11.

## Description

### BACKGROUND

### 1. Technical Field

The present disclosure relates to a thermoelectric conversion element, a thermoelectric conversion module, a thermoelectric conversion system, a method for generating electrical power, and a method for manufacturing a thermoelectric conversion element.

### Background Art

In the related art, thermoelectric conversion elements are known. For example, an N-type thermoelectric conversion element including an N-type thermoelectric conversion material can be electrically connected to a P-type thermoelectric conversion element including a P-type thermoelectric conversion material to provide a thermoelectric conversion module. A known approach for facilitating the electrical connection between the thermoelectric conversion elements is to form a layer of a metal material on an end surface portion of the thermoelectric conversion material.

Patent Literature 1, for example, describes a magnesium-antimony-based thermoelectric element. This thermoelectric element includes a magnesium-antimony-based thermoelectric material substrate layer positioned in the center of the thermoelectric element, transition layers attached to two surfaces of the substrate layer, and electrode layers attached to surfaces of the two transition layers. The transition layers are made of a magnesium-copper alloy and/or a magnesium-aluminum alloy. The electrode layers are made of copper.

Patent Literature 2 describes a magnesium-antimony-based thermoelectric element. This thermoelectric element includes a magnesium-antimony-based thermoelectric material substrate layer positioned in the center of the thermoelectric element, transition layers attached to two surfaces of the substrate layer, and electrode layers attached to surfaces of the two transition layers. The transition layers are made of a titanium-copper alloy or a magnesium-copper alloy. The electrode layers are copper and/or nickel.

Patent Literature 3 describes a thermoelectric conversion element including electrodes, intermediate layers, and a thermoelectric conversion layer. The intermediate layers are each provided between the thermoelectric conversion layer and the electrode. The intermediate layers are in contact with the thermoelectric conversion layer. The thermoelectric conversion layer contains Mg, at least one element selected from the group consisting of Sb and Bi, and at least one element selected from the group consisting of Se and Te. The electrodes are composed of a CuZn alloy. The composition of the intermediate layers are different from the composition of the electrodes and the composition of the thermoelectric conversion layer. The intermediate layers contain Cu, Zn, and Mg.

Patent Literature 4 describes a MgAlB₁₄-system n-type thermoelectric material. This thermoelectric material includes an oxide phase.

### CITATION LIST

### Patent Literature

PTL 1: Chinese Patent No. 111613715
PTL 2: Chinese Patent No. 110635020
PTL 3: International Publication No. 2020/003554
PTL 4: Japanese Unexamined Patent Application Publication No. 2013-211370

### SUMMARY

### Technical Problem

The present disclosure provides a thermoelectric conversion element that is advantageous in terms of decreasing an electrical resistance of thermoelectric conversion elements that include a thermoelectric conversion material containing Mg.

### Solution to Problem

According to the present disclosure, a thermoelectric conversion element comprises a first metal layer, a second metal layer, and a thermoelectric conversion layer that is disposed between the first metal layer and the second metal layer in a thickness direction of the first metal layer and comprises a thermoelectric conversion material comprising Mg, wherein the first metal layer comprises a first region and a second region, the first region being disposed within an interior of the first metal layer and comprising oxygen atoms, the second region being different from the first region, and an atomic content of the oxygen atoms in the first region is higher than an atomic content of oxygen atoms in the second region of the first metal layer and is higher than an atomic content of oxygen atoms in the thermoelectric conversion layer.

### Advantageous Effects of Invention

The present disclosure can provide a thermoelectric conversion element that includes a thermoelectric conversion material containing Mg and that is advantageous in terms of decreasing an electrical resistance of thermoelectric conversion elements.

### Brief Description of Drawings

[Fig. 1A] Fig. 1A is a schematic cross-sectional view illustrating an exemplary thermoelectric conversion element of a first embodiment.
[Fig. 1B] Fig. 1B is a schematic cross-sectional view illustrating another exemplary thermoelectric conversion element.
[Fig. 1C] Fig. 1C is a schematic cross-sectional view illustrating yet another exemplary thermoelectric conversion element.
[Fig. 1D] Fig. 1D is a schematic cross-sectional view illustrating still another exemplary thermoelectric conversion element.
[Fig. 1E] Fig. 1E is a schematic cross-sectional view illustrating yet another exemplary thermoelectric conversion element.
[Fig. 1F] Fig. 1F is a schematic cross-sectional view illustrating still another exemplary thermoelectric conversion element.
[Fig. 2] Fig. 2 is a schematic diagram illustrating a La₂O₃-type crystal structure.
[Fig. 3] Fig. 3 is a flowchart illustrating a method for manufacturing the thermoelectric conversion element of the first embodiment.
[Fig. 4] Fig. 4 is a cross-sectional view illustrating an exemplary thermoelectric conversion module of a second embodiment.
[Fig. 5] Fig. 5 is a cross-sectional view illustrating another exemplary thermoelectric conversion module of the second embodiment.
[Fig. 6] Fig. 6 is a cross-sectional view illustrating yet another exemplary thermoelectric conversion module of the second embodiment.
[Fig. 7] Fig. 7 is a side view illustrating a thermoelectric conversion system of a third embodiment.
[Fig. 8] Fig. 8 is a photograph showing a thermoelectric conversion element of the working example 1.
[Fig. 9] Fig. 9 is a schematic diagram illustrating a manner of measuring an electrical resistance of a thermoelectric conversion element.
[Fig. 10] Fig. 10 is a graph showing exemplary results of measuring the electrical resistance of the thermoelectric conversion element of the working example 1.
[Fig. 11] Fig. 11 is a graph illustrating an atomic concentration profile obtained through a composition line analysis performed on a cross section of a thermoelectric conversion element of the working example 1 by Auger electron spectroscopy (AES).
[Fig. 12] Fig. 12 is a micrograph of a cross section of the thermoelectric conversion element of the working example 1, the micrograph having been obtained by scanning transmission electron microscope and energy dispersive X-ray spectroscopy.
[Fig. 13A] Fig. 13A is a diagram illustrating a distribution of oxygen atoms in a field of view of the micrograph shown in Fig. 12.
[Fig. 13B] Fig. 13B is a diagram illustrating a distribution of copper atoms in the field of the view of the micrograph shown in Fig. 12.

### DESCRIPTION OF EMBODIMENTS

### (Underlying Knowledge Forming Basis of the Present Disclosure)

Possible methods for forming a metal layer include electrolytic plating and electroless plating. If an oxide having a high electrical resistance is present at an interface between the plated material and the plating material, the system as a whole may have an increased electrical resistance. The same applies to techniques for forming a metal layer other than plating, such as thermal spraying.

The present inventors conducted studies and found that in instances where, for example, a metal layer containing a metal, such as Cu, is formed on a layer including a thermoelectric conversion material containing Mg, by using a plating method or the like, an interface resistivity between the metal layer and the layer including a thermoelectric conversion material is likely to increase. In further studies conducted by the present inventors, a layer containing an oxide was observed between the metal layer and the layer including a thermoelectric conversion material, and this layer containing an oxide was presumed to be a cause of the increase in the interface resistivity.

Patent Literature 1, 2, and 3 describe some materials that can serve as the metal layer that is to be in contact with the layer including a thermoelectric conversion material containing Mg. Patent Literature 1, 2, and 3, however, fail to state that a region containing oxygen is present at or near the interface between the metal layer and the layer including a thermoelectric conversion material. Patent Literature 4 states that the thermoelectric conversion material containing Mg includes an oxide phase by itself. Patent Literature 4, however, is silent as to the presence of an oxide at the interface between the metal layer and the layer including the thermoelectric conversion material.

The present inventors made numerous trial-and-error attempts to solve the problems that may occur in the instance where a metal layer is formed in contact with the layer including a thermoelectric conversion material containing Mg. As a result, the present inventors newly discovered that in instances where a metal layer is formed in contact with the thermoelectric conversion layer including a thermoelectric conversion material containing Mg, and thereafter, a specific treatment is performed, the metal layer is adjusted to be placed in a predetermined state, which enables the interface resistivity between the metal layer and the layer including the thermoelectric conversion material to be decreased. Based on this new finding, the present inventors completed the thermoelectric conversion element of the present disclosure.

### (Embodiments of the Present Disclosure)

Embodiments of the present disclosure will be described below with reference to the drawings.

### (First Embodiment)

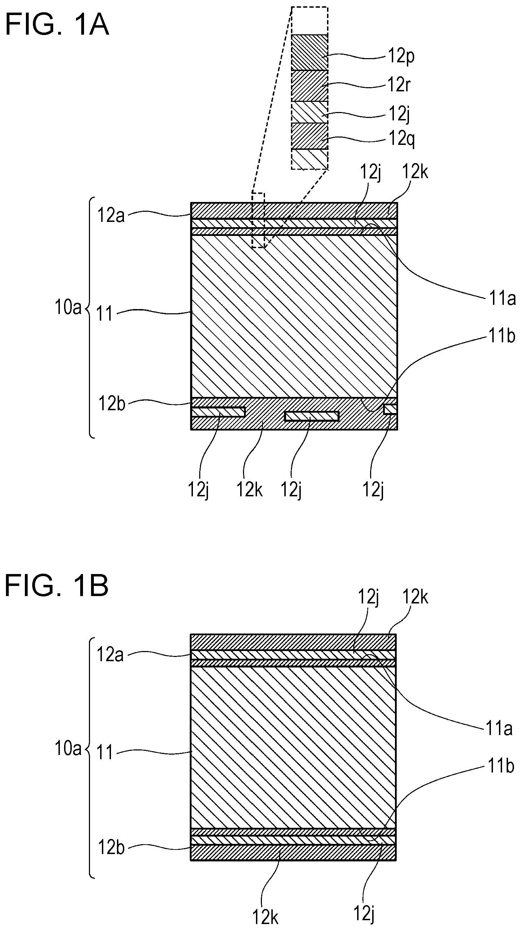

Fig. 1A is a schematic cross-sectional view illustrating an exemplary thermoelectric conversion element of the first embodiment. As illustrated in Fig. 1A, a thermoelectric conversion element 10a includes a first metal layer 12a, a second metal layer 12b, and a thermoelectric conversion layer 11. The thermoelectric conversion layer 11 is disposed between the first metal layer 12a and the second metal layer 12b in a thickness direction of the first metal layer 12a. The thermoelectric conversion layer 11 includes a thermoelectric conversion material containing Mg. The first metal layer 12a includes a first region 12j and a second region 12k. The first region 12j contains oxygen atoms. The second region 12k is different from the first region 12j. The first region 12j is disposed within an interior of the first metal layer 12a. In other words, the first region 12j is present at a position spaced from a boundary between the first metal layer 12a and an outside of the first metal layer 12a. For example, the first region 12j is not in contact with the thermoelectric conversion layer 11 and is present at a position spaced from the thermoelectric conversion layer 11. An atomic content of the oxygen atoms in the first region 12j is higher than an atomic content of oxygen atoms in the second region 12k of the first metal layer 12a. In addition, the atomic content of the oxygen atoms in the first region 12j is higher than an atomic content of oxygen atoms in the thermoelectric conversion layer 11.

In the instance where the first region 12j is disposed within the interior of the first metal layer 12a, an interface resistivity at an interface between the first metal layer 12a and the outside of the first metal layer 12a is likely to be decreased. Consequently, the thermoelectric conversion element 10a is likely to have a low electrical resistance.

The thermoelectric conversion layer 11 has, for example, a first end 11a and a second end 11b in the thickness direction of the first metal layer 12a. The first metal layer 12a is, for example, in contact with the first end 11a. In this instance, since the first region 12j is disposed within the interior of the first metal layer 12a, the interface resistivity at the interface between the first metal layer 12a and the thermoelectric conversion layer 11 is likely to be decreased. The second metal layer 12b is, for example, in contact with the second end 11b.

The second metal layer 12b has, for example, a configuration similar to that of the first metal layer 12a. The second metal layer 12b includes a first region 12j and a second region 12k, which is different from the first region 12j, within an interior of the second metal layer 12b. In the second metal layer 12b, an atomic content of oxygen atoms in the first region 12j is higher than an atomic content of oxygen atoms in the second region 12k of the second metal layer 12b. In addition, the atomic content of the oxygen atoms in the first region 12j is higher than an atomic content of oxygen atoms in the thermoelectric conversion layer 11. The descriptions of the first metal layer 12a apply to the second metal layer 12b as long as there is no technical inconsistency.

A shape of the first region 12j may be the same or different between the first metal layer 12a and the second metal layer 12b. The first region 12j may be present in the form of a layer, or the first region 12j may be present in the form of pieces, for example. As an example, as illustrated in Fig. 1A, a first region 12j in the form of a layer is present in the first metal layer 12a, and a first region 12j in the form of multiple pieces separated from one another is present in the second metal layer 12b.

Fig. 1B is a schematic cross-sectional view illustrating another exemplary thermoelectric conversion element 10a. As illustrated in Fig. 1B, a first region 12j in the form of a layer may be present in the first metal layer 12a and the second metal layer 12b.

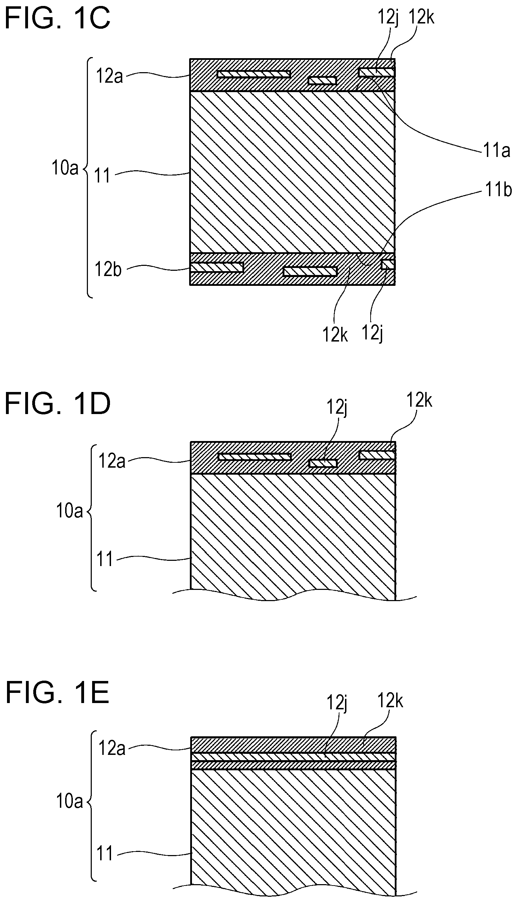

Fig. 1C is a schematic cross-sectional view illustrating yet another exemplary thermoelectric conversion element. As illustrated in Fig. 1C, a first region 12j in the form of multiple pieces separated from one another may be present in the first metal layer 12a and the second metal layer 12b.

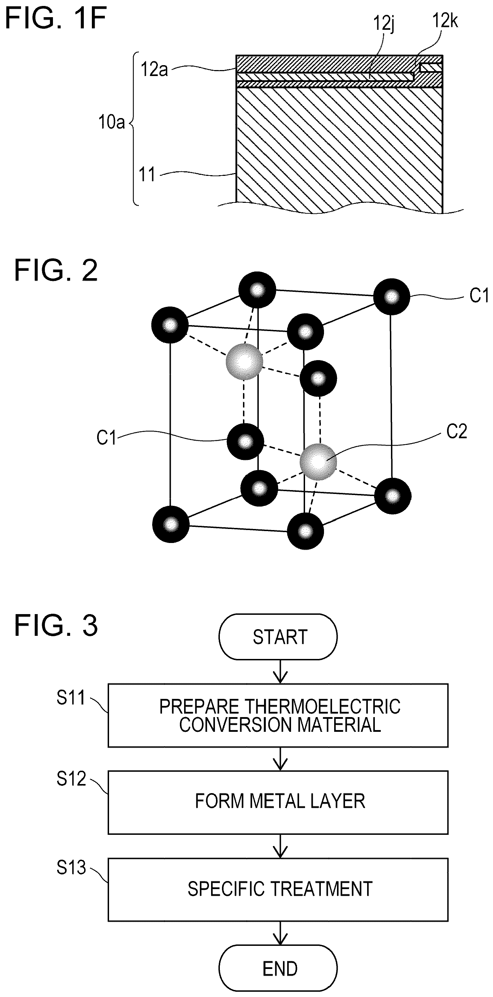

Figs. 1D, 1E, and 1F are each a schematic cross-sectional view illustrating still another exemplary thermoelectric conversion element. Of the first metal layer 12a and the second metal layer 12b, the first metal layer 12a may exclusively include the first region 12j. In this instance, as illustrated in Fig. 1D, a first region 12j in the form of multiple pieces separated from one another, for example, may be present in the first metal layer 12a. As illustrated in Fig. 1E, a first region 12j in the form of a layer may be present in the first metal layer 12a. As illustrated in Fig. 1F, a first region 12j in the form of a layer and a first region 12j in the form of pieces may be present and spaced from each other in the first metal layer 12a.

As an example, the first region 12j further contains Mg. In this instance, the interface resistivity at the interface between the first metal layer 12a and the outside of the first metal layer 12a is likely to be further decreased, which makes it likely that the thermoelectric conversion element 10a has a lower electrical resistance.

As an example, as illustrated in Fig. 1A, the first metal layer 12 further includes a first electrode layer 12p and a first intermediate layer 12q. The first electrode layer 12p contains Cu. The first intermediate layer 12q is disposed between the first electrode layer 12p and the thermoelectric conversion layer 11 in the thickness direction of the first metal layer 12 and contains Mg and Cu. The first region 12j is present between the first intermediate layer 12q and the first electrode layer 12p in the thickness direction of the first metal layer 12. With this configuration, the interface resistivity at the interface between the first metal layer 12a and the outside of the first metal layer 12a is likely to be further decreased, which makes it likely that the thermoelectric conversion element 10a has a lower electrical resistance.

As an example, as illustrated in Fig. 1A, the first metal layer 12a further includes a second intermediate layer 12r. The second intermediate layer 12r is disposed between the first electrode layer 12p and the first intermediate layer 12q in the thickness direction of the first metal layer 12a and contains Mg and Cu. The first region 12j is present between the first intermediate layer 12q and the second intermediate layer 12r in the thickness direction of the first metal layer 12a. With this configuration, the interface resistivity at the interface between the first metal layer 12a and the outside of the first metal layer 12a is likely to be further decreased, which makes it likely that the thermoelectric conversion element 10a has a lower electrical resistance.

The presence of the first intermediate layer 12q and the second intermediate layer 12r in the first metal layer 12a can be confirmed, for example, by observing a cross section of the first metal layer 12a with a transmission electron microscope (TEM) or an analytical electron microscope (AEM).

The first intermediate layer 12q and the second intermediate layer 12r are formed, for example, as diffusion layers. The first intermediate layer 12q and the second intermediate layer 12r are formed, for example, by diffusing Mg derived from a raw material of the thermoelectric conversion layer 11, in the first metal layer 12a.

Variations in an atomic concentration of oxygen atoms in the thickness direction of the first metal layer 12a are not limited to any particular manner. The variations in the concentration satisfy, for example, a condition of 0.5% ≤ α at a position corresponding to the first region 12j. The variations in the concentration can be obtained through a composition line analysis performed on a cross section of the first metal layer 12a in the thickness direction of the first metal layer 12a by Auger electron spectroscopy. α is the maximum value of the concentration of oxygen atoms among the variations in the concentration. With this configuration, the interface resistivity at the interface between the first metal layer 12a and the outside of the first metal layer 12a is likely to be further decreased, which makes it likely that the thermoelectric conversion element 10a has a lower electrical resistance.

The variations in the concentration may satisfy a condition of 1% ≤ α, a condition of 2% ≤ α, a condition of 5% ≤ α, or a condition of 10% ≤ α.

The variations in the concentration satisfy, for example, a condition of α ≤ 50%. In this instance, the interface resistivity at the interface between the first metal layer 12a and the outside of the first metal layer 12a is likely to be further decreased, which makes it likely that the thermoelectric conversion element 10a has a lower electrical resistance.

The variations in the concentration may satisfy a condition of α ≤ 45%, a condition of α ≤ 40%, or a condition of α ≤ 35%. The variations in the concentration may satisfy, for example, a condition of α_{L} ≤ α ≤ α_{H}. In this condition, α_{L} is one selected from the group consisting of 0.5%, 1%, 2%, 5%, and 10%, and α_{H} is one selected from the group consisting of 35%, 40%, 45%, and 50%.

The state of the interface between the first metal layer 12a and the outside of the first metal layer 12a can be evaluated, for example, by AES and TEM. An example is as follows. The thermoelectric conversion element 10a is introduced into an AES apparatus, and reverse sputtering is performed on a side surface of the thermoelectric conversion element 10a, with an Ar ion gun mounted in the apparatus. Thus, a clean surface that is the surface to be analyzed by AES is formed. The conditions for the reverse sputtering can be desired conditions that are determined from the standpoint of a reverse sputtering rate and surface damage. The reverse sputtering rate is defined by an acceleration voltage and irradiation area of the Ar ion gun. As an example, the acceleration voltage is 1 kV, and a processing area is 500 µm². The reverse sputtering may be performed until carbon atoms (C) and oxygen atoms (O) on the surface substantially disappear. For example, by performing reverse sputtering for approximately 1 minute, it is possible to obtain a clean surface on which C and O on the surface of the thermoelectric conversion element 10a have substantially disappeared.

A composition line analysis is performed on the clean surface obtained as described above to obtain a line profile of the cross section of the sample. In the composition line analysis, at least Mg, Cu, and O are to be analyzed. Other elements may also be analyzed. The conditions for the composition line analysis may be appropriately selected for each of the elements. As an example, the composition line analysis may be performed under the conditions of an acceleration voltage of 10 kV, a probe current of 10 nA, and a magnification of 20000×.

The evaluation of the state of the interface can be carried out with a TEM. An example of the manner of preparing for the TEM observation is as follows. First, a protective film is formed on the region that is to be observed, by depositing Pt thereon with a predetermined method. An example of the deposition method is ion-beam-assisted deposition. Subsequently, the region that is to be observed is processed with a predetermined method to produce a sample having a shape suitable for the analyzer. An example of the processing method is a focused ion beam method. Elemental analysis can be carried out using the TEM and an energy dispersive X-ray spectroscopy (EDX) on the sample prepared in the described manner,

The shape of the thermoelectric conversion element 10a is not limited to any particular shape. For example, the thermoelectric conversion element 10a is generally rectangular-parallelepiped-shaped. The shape of the thermoelectric conversion element 10a may be any shape in which the thermoelectric conversion layer 11 containing a thermoelectric conversion material can be formed. The shape may be, for example, a rectangular parallelepiped shape, a cubic shape, a generally cubic shape, any other prismatic shape, a generally prismatic shape, a cylindrical shape, or a tubular shape.

The thickness of the thermoelectric conversion layer 11 is not limited to any particular value. The thickness is, for example, greater than or equal to 0.1 mm and less than or equal to 5.0 mm.

The thermoelectric conversion material that is included in the thermoelectric conversion layer 11 is not limited to any particular material as long as the thermoelectric conversion material contains Mg. For example, the thermoelectric conversion material further contains at least one selected from the group consisting of Sb and Bi. In this instance, the thermoelectric conversion element 10a is likely to exhibit desired thermoelectric properties. The thermoelectric conversion material is, for example, an N-type thermoelectric conversion material.

The thermoelectric conversion material that is included in the thermoelectric conversion layer 11 has, for example, a La₂O₃-type crystal structure. In this instance, the thermoelectric conversion element 10a is more likely to exhibit desired thermoelectric properties. Whether the thermoelectric conversion material has a La₂O₃-type crystal structure can be determined, for example, based on the results of an X-ray diffraction measurement of a sample of the thermoelectric conversion material. Fig. 2 is a schematic diagram illustrating a La₂O₃-type crystal structure. In the instance where the thermoelectric conversion material has a La₂O₃-type crystal structure, an example is as follows: referring to Fig. 2, Mg is positioned at a C1 site, and at least one selected from the group consisting of Sb and Bi is positioned at a C2 site. As illustrated in Fig. 2, a bond, indicated by the dashed line, is formed between the C1 site and the C2 site.

The thermoelectric conversion material, for example, further contains Te. In this instance, the thermoelectric conversion element 10a is more likely to exhibit desired thermoelectric properties.

The thermoelectric conversion material has, for example, a composition represented by Mg₃₊ₘRₐT_{b}Sb_{2-e-c}Bi_{c}Zₑ. In this composition, the element R is at least one element selected from the group consisting of Ca, Sr, Ba, and Yb. The element T is at least one element selected from the group consisting of Mn and Zn. The element Z is at least one element selected from the group consisting of Te, Se, Sc, Y, and La. The value of m satisfies -0.39 ≤ m ≤ 0.42. The value of a satisfies 0 ≤ a ≤ 0.12. The value of b satisfies 0 ≤ b ≤ 0.48. The value of c satisfies 0 ≤ c ≤ 1.6. The value of e satisfies 0.001 ≤ e ≤ 0.06. In this instance, the thermoelectric conversion element 10a is more likely to exhibit desired thermoelectric properties.

As illustrated in Fig. 1, the first metal layer 12a and the second metal layer 12b each constitute, for example, an end surface of the thermoelectric conversion element 10a in the thickness direction of the first metal layer 12a. The thickness of each of the first metal layer 12a and the second metal layer 12b is not limited to any particular value. The thickness is, for example, greater than or equal to 0.5 µm and less than or equal to 100 µm and is desirably greater than or equal to 0.5 µm and less than or equal to 10 µm. The thickness of the first metal layer 12a and the thickness of the second metal layer 12b may be the same as or different from each other. The first metal layer 12a and the second metal layer 12b are, for example, Cu or alloys containing Cu. The first metal layer 12a and the second metal layer 12b may each include a diffusion layer that is a portion resulting from the diffusion of a metal derived from raw materials of the thermoelectric conversion layer 11. The diffusion layer may be formed only in one of the first metal layer 12a and the second metal layer 12b or may be formed in both of the first metal layer 12a and the second metal layer 12b. In the instance where diffusion layers are present in both of the first metal layer 12a and the second metal layer 12b, the thickness and the composition of the diffusion layers may be the same or different between the first metal layer 12a and the second metal layer 12b. Examples of the alloys containing Cu include alloys containing Cu and at least one selected from the group consisting of Mg, Sb, Bi, Te, and Zn. The alloy is, for example, formed of Cu and at least one selected from the group consisting of Mg, Sb, Bi, Te, and Zn that are derived from the raw material of the thermoelectric conversion layer 11 and have diffused within the first metal layer 12a or the second metal layer 12b. Thus, the first metal layer 12a or the second metal layer 12b can contain such an alloy.

The thermoelectric conversion element 10a may include an additional layer, such as an electrode layer for, for example, establishing connection to an electrical circuit and preventing oxidation of an electrode. The additional layer may be disposed on a surface that is not in contact with the first end 11a or the second end 11b in the thickness direction of the first metal layer 12a or the second metal layer 12b. The additional layer may be a single layer or multiple layers. An example of the additional layer is a layer having a structure in which a Ni layer and a Au layer are formed in this order on the first metal layer 12a or the second metal layer 12b in the thickness direction of the first metal layer 12a or the second metal layer 12b. Regarding the layers that are formed on the first metal layer 12a and the second metal layer 12b, the composition of the material, the structure of the layers, and the thickness of the layers may be the same as or different from each other. A diffusion layer may or does not have to be present between layers.

The thermoelectric conversion element 10a can be manufactured, for example, by performing a specific treatment on a stack of layers that includes a precursor of the thermoelectric conversion layer 11 and a precursor of a metal layer. The precursor of the metal layer is formed in contact with the precursor of the thermoelectric conversion layer 11. The specific treatment includes heating the stack of layers. Consequently, the precursor of the thermoelectric conversion layer 11 becomes the thermoelectric conversion layer 11, and the precursor of the metal layer becomes the first metal layer 12a or the second metal layer 12b.

Fig. 3 is a flowchart illustrating a method for manufacturing the thermoelectric conversion element of the first embodiment. In step S11, the thermoelectric conversion material is prepared, as illustrated in Fig. 3. An example of a method for preparing the thermoelectric conversion material is described below. Methods for preparing the thermoelectric conversion material are not limited to the method described below.

A solid-state reaction is caused between raw materials that are in a mixed state. The raw materials are Mg particles and at least one type of particles selected from the group consisting of Sb particles and Bi particles. In this way, a powdered alloy containing Mg and at least one selected from the group consisting of Sb and Bi can be prepared. The raw materials may be selected such that the powdered alloy contains a metal other than Sb or Bi. In the solid-state reaction, a powder of a dopant element may be mixed together as necessary. The raw materials may be particles or powders. An example of a method for causing the solid-state reaction is mechanical alloying. The alloy may be prepared by a method other than the solid-state reaction, which may be, for example, a melting method or the like.

Subsequently, the powdered alloy is sintered to form a single-crystal or polycrystalline alloy. The sintering of the powdered alloy can be accomplished, for example, by a spark plasma sintering method or a hot-press method. The resulting sintered body can be used directly as the thermoelectric conversion material. The resulting sintered body may be subjected to heat treatment, and the heat-treated sintered body may be used as the thermoelectric conversion material.

Next, in step S12, the precursor of the metal layer is formed in contact with an end surface of the precursor of the thermoelectric conversion layer that includes the thermoelectric conversion material. Methods for forming the precursor of the metal layer are not limited to any particular method. Examples of methods for forming the precursor of the metal layer include electroplating, electroless plating, sputtering, and thermal spraying. In the instance where the precursor of the metal layer is formed by electroplating, a commercially available plating liquid may be used. After completion of the plating, a washing process for removing the plating liquid may be performed.

Next, in step S13, the specific treatment, which includes heating the stack of layers including the precursor of the thermoelectric conversion layer and the precursor of the metal layer, is performed on the precursor of the metal layer. Consequently, the first region 12j is formed within the interior of the first metal layer 12a. The specific treatment may be, for example, a treatment that includes heating the stack of layers to produce a flow of current therein such that the heating is based on conditions under which the thermoelectric conversion element 10a is expected to be used. A duration of the specific treatment may be selected in accordance with the properties required of the thermoelectric conversion element 10a. For example, the duration of the specific treatment is 500 hours. In the manner that has been described, the thermoelectric conversion element 10a can be manufactured. The specific treatment may be performed after completion of assembling for manufacturing a thermoelectric conversion module, which will be described below. The specific treatment may be performed multiple times. For example, the specific treatment may be performed both in a state in which the element is yet to be subjected to the assembling for manufacturing a thermoelectric conversion module and in a state in which the assembling for manufacturing a thermoelectric conversion module has been completed.

The specific treatment is carried out, for example, such that an absolute value of |ΔY/(Y(t)Δt)| is less than or equal to a predetermined value. ΔY is an amount of change in a specified property of the element over a period from a time t to a time t+Δt. Y(t) is a value of the specified property of the element at the time t. The specified property of the element is, for example, the electrical resistance of the element.

### (Second Embodiment)

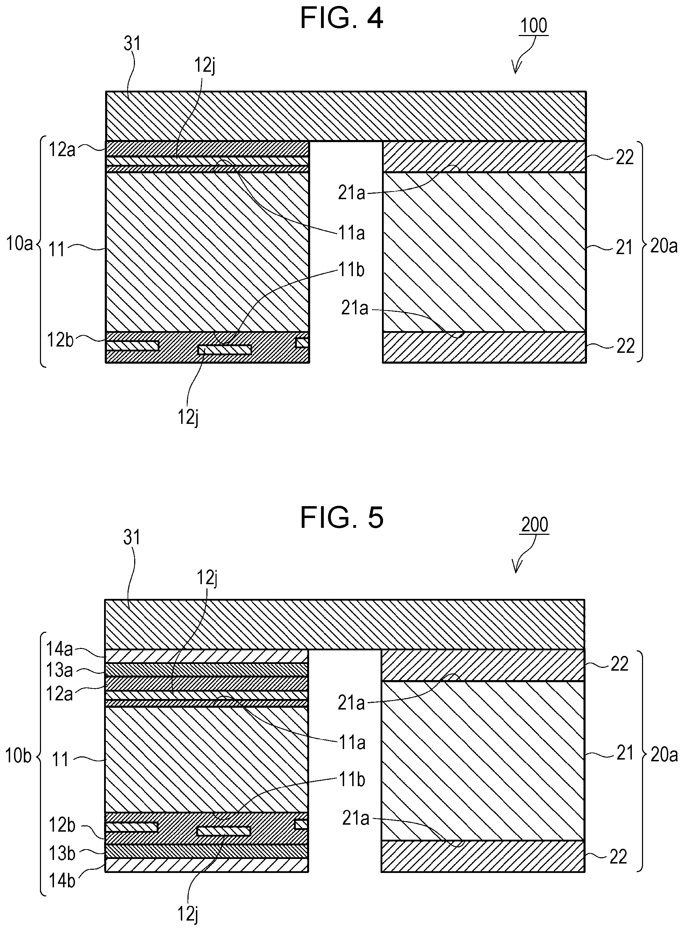

Fig. 4 is a cross-sectional view illustrating an exemplary thermoelectric conversion module of the second embodiment. As illustrated in Fig. 4, a thermoelectric conversion module 100 includes a P-type thermoelectric element 20a, an N-type thermoelectric element, which is a thermoelectric conversion element 10a, and an electrode 31. The electrode 31 electrically connects a first end portion of the P-type thermoelectric conversion element 20a to a first end portion of the N-type thermoelectric conversion element 10a. A first metal layer 12a may be directly connected to the electrode 31, or another layer may be disposed between the electrode 31 and the first metal layer 12a.

As illustrated in Fig. 4, the P-type thermoelectric element 20a includes, for example, a thermoelectric conversion layer 21 and a pair of electrode layers 22. The electrode layers 22 are each in contact with a second surface 21a of the thermoelectric conversion layer 21. The second surfaces 21a are end surfaces of the thermoelectric conversion layer 21 in a thickness direction of the electrode layers 22. The pair of electrode layers 22 are in contact with both end surfaces of the thermoelectric conversion layer 21 in the thickness direction of the electrode layers 22. The electrode layers 22 may be directly connected to the electrode 31, or another layer may be disposed between the electrode 31 and the electrode layers 22. The manner in which the P-type thermoelectric element 20a is connected to an external electrode may be the same as or different from the manner in which the N-type thermoelectric conversion element 10a is connected to an external electrode.

The thermoelectric conversion layer 21 includes a P-type thermoelectric conversion material. Examples of the P-type thermoelectric conversion material include bismuth telluride, cesium bismuth telluride, germanium telluride, bismuth antimony, Mg₃(Sb,Bi)₂, and MgAgSb. "(Sb,Bi)" means that at least one selected from the group consisting of Sb and Bi is contained. The N-type thermoelectric conversion material included in a thermoelectric conversion layer 11 and the P-type thermoelectric conversion material included in the thermoelectric conversion layer 21 may be materials of the same type of alloy system or materials of different types of alloy systems. The expression "of the same type of alloy system" means having the same alloy-forming elements. From the standpoint of decreasing a thermal stress in the thermoelectric conversion module 100, it is important that the difference in a coefficient of thermal expansion between the N-type thermoelectric conversion material included in the thermoelectric conversion layer 11 and the P-type thermoelectric conversion material included in the thermoelectric conversion layer 21 be small. For example, when the P-type thermoelectric conversion material is Mg₃(Sb,Bi)₂ or bismuth telluride, the difference in the coefficient of thermal expansion between the N-type thermoelectric conversion material and the P-type thermoelectric conversion material tends to be small.

When the P-type thermoelectric conversion material is bismuth telluride, the electrode layers 22 are, for example, Ni-plated layers, Ni-thermal-sprayed layers, Nisputtered layers, Mo-thermal-sprayed layers, or the like. When the P-type thermoelectric conversion material is bismuth telluride and has a composition represented by Bi₂Teₓ, x in this composition satisfies, for example, the condition of 2 < x < 4. The composition of the bismuth telluride may be Bi₂Te₃. The bismuth telluride may contain at least one selected from the group consisting of antimony and selenium. The bismuth telluride containing antimony has a composition of, for example, (Bi_{1-y}Sb_{y})₂Teₓ. When the P-type thermoelectric conversion material has the composition of (Bi_{1-y}Sb_{y})₂Teₓ, the condition of 0 < y < 1, for example, is satisfied, and desirably, the condition of 0.6 < y < 0.9 is satisfied.

Fig. 5 is a cross-sectional view illustrating another exemplary thermoelectric conversion module. As illustrated in Fig. 5, a thermoelectric conversion module 200 has the same configuration as that of the thermoelectric conversion module 100, except that the thermoelectric conversion module 200 includes a thermoelectric conversion element 10b as the N-type thermoelectric conversion element instead of the thermoelectric conversion element 10a. The thermoelectric conversion element 10b has the same configuration as that of the thermoelectric conversion element 10a, except for portions that are particularly described. Constituent elements of the thermoelectric conversion element 10b that are the same as or correspond to the constituent elements of the thermoelectric conversion element 10a are assigned the same reference numerals, and details thereof will not be described. The descriptions of the thermoelectric conversion element 10a apply to the thermoelectric conversion element 10b as long as there is no technical inconsistency.

As illustrated in Fig. 5, the thermoelectric conversion element 10b includes a first metal layer 12a, an electrode layer 13a, an electrode layer 14a, a second metal layer 12b, an electrode layer 13b, and an electrode layer 14b. The first metal layer 12a, the electrode layer 13a, and the electrode layer 14a are disposed in this order in the thermoelectric conversion element 10b, starting from a first end 11a of the thermoelectric conversion layer 11, in a thickness direction of the first metal layer 12a. The thermoelectric conversion layer 11 is electrically connected to an electrode 31 via the first metal layer 12a, the electrode layer 13a, and the electrode layer 14a. The second metal layer 12b, the electrode layer 13b, and the electrode layer 14b are disposed in this order in the thermoelectric conversion element 10b, starting from a second end 11b of the thermoelectric conversion layer 11, in a thickness direction of the second metal layer 12b.

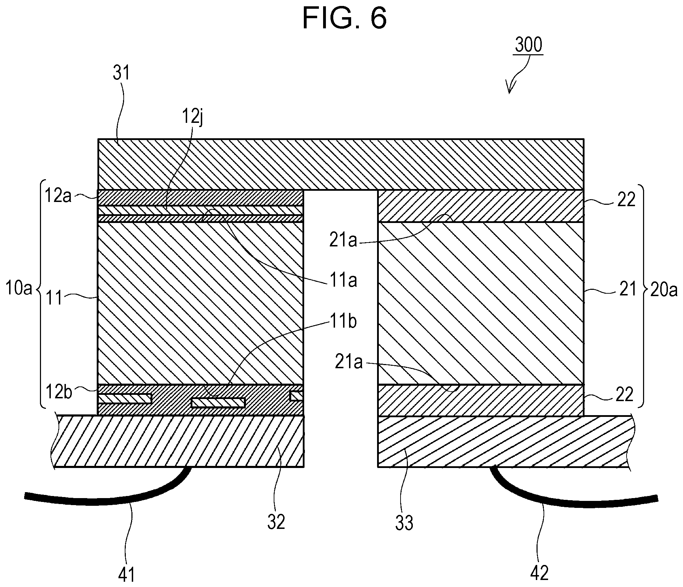

Fig. 6 is a cross-sectional view illustrating yet another exemplary thermoelectric conversion module. A thermoelectric conversion module 300, illustrated in Fig. 6, has the same configuration as that of the thermoelectric conversion module 100, except for portions that are particularly described. As illustrated in Fig. 6, the thermoelectric conversion module 300 further includes an electrode 32 and an electrode 33. A second end portion of an N-type thermoelectric conversion element 10a is electrically connected to the electrode 32 via a second metal layer 12b. A second end portion of a P-type thermoelectric conversion element 20a is electrically connected to the electrode 33 via an electrode layer 22. The thermoelectric conversion module 300 further includes a first wiring 41 and a second wiring 42. The first wiring 41 is connected to the electrode 32. The second wiring 42 is connected to the electrode 33. The first wiring 41 and the second wiring 42 serve to, for example, apply a voltage to the N-type thermoelectric conversion element 10a and the P-type thermoelectric conversion element 20a. The first wiring 41 and the second wiring 42 may serve to supply electricity generated in the thermoelectric conversion module 300 to an outside of the thermoelectric conversion module 100.

### (Third Embodiment)

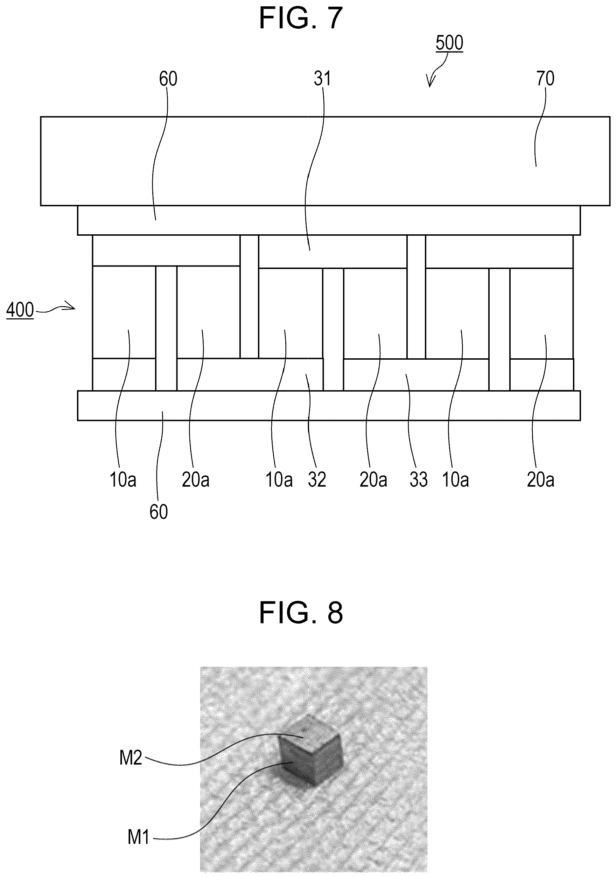

Fig. 7 is a side view illustrating a thermoelectric conversion system of the third embodiment. As illustrated in Fig. 7, a thermoelectric conversion system 500 includes a thermoelectric conversion module 400 and a heat source 70. The thermoelectric conversion module 400 has the same configuration as that of the thermoelectric conversion module 100, except for portions that are particularly described. The thermoelectric conversion module 400 includes an electrode 31, an electrode 32, and an electrode 33. The heat source 70 is disposed adjacent to the electrode 31. The electrode 32 and the electrode 33 each electrically connect a second end portion of the P-type thermoelectric conversion element 20a to a second end portion of the N-type thermoelectric conversion element 10a.

The thermoelectric conversion system 500 further includes, for example, a pair of substrates 60. One of the pair of substrates 60 is disposed in contact with the electrode 31, and the other of the pair of substrates 60 is disposed in contact with the electrode 32 and the electrode 33. This configuration makes it unlikely that temperature variations occur in a direction parallel to a major surface of the substrates 60 in the thermoelectric conversion system 500. The material of the substrates 60 is not limited to any particular material. For example, the substrates 60 contain alumina or aluminum nitride.

With the thermoelectric conversion system 500, it is possible to provide a method for generating electrical power that includes generating electrical power by applying a temperature difference to the thermoelectric conversion module 400 by using heat from the heat source 70.

The thermoelectric conversion elements of the above-described embodiments can be used in a variety of applications, including, for example, applications of thermoelectric conversion elements of the related art. The thermoelectric conversion modules 100, 200, 300, and 400 can be manufactured by assembling the N-type thermoelectric conversion element 10a or 10b with the P-type thermoelectric conversion element 20a by a method known in the art.

### (Supplementary Notes)

According to what has been described above, the following technologies are disclosed.

### (Technology 1)

A thermoelectric conversion element comprising:
a first metal layer;
a second metal layer; and
a thermoelectric conversion layer that is disposed between the first metal layer and the second metal layer in a thickness direction of the first metal layer and comprises a thermoelectric conversion material comprising Mg, wherein
the first metal layer comprises a first region and a second region, the first region being disposed within an interior of the first metal layer and comprising oxygen atoms, the second region being different from the first region, and
an atomic content of the oxygen atoms in the first region is higher than an atomic content of oxygen atoms in the second region of the first metal layer and is higher than an atomic content of oxygen atoms in the thermoelectric conversion layer.

### (Technology 2)

The thermoelectric conversion element according to Technology 1, wherein the thermoelectric conversion material further comprises at least one selected from the group consisting of Sb and Bi.

### (Technology 3)

The thermoelectric conversion element according to Technology 1 or 2, wherein the first region further comprises Mg.

### (Technology 4)

The thermoelectric conversion element according to any one of Technologies 1 to 3, wherein
the first metal layer further comprises a first electrode layer and a first intermediate layer, the first electrode layer comprising Cu, the first intermediate layer being disposed between the first electrode layer and the thermoelectric conversion layer in the thickness direction of the first metal layer and comprising Mg and Cu, and
the first region is present between the first intermediate layer and the first electrode layer in the thickness direction of the first metal layer.

### (Technology 5)

The thermoelectric conversion element according to any one of Technologies 1 to 3, wherein
the first metal layer further comprises a second intermediate layer disposed between the first electrode layer and the first intermediate layer in the thickness direction of the first metal layer and comprising Mg and Cu, and
the first region is present between the first intermediate layer and the second intermediate layer in the thickness direction of the first metal layer.

### (Technology 6)

The thermoelectric conversion element according to any one of Technologies 1 to 5, wherein
variations in an atomic concentration of oxygen atoms in the thickness direction of the first metal layer satisfy a first condition expressed as 0.5% ≤ α, at a position corresponding to the first region,
the variations in the concentration are obtained through a composition line analysis performed on a cross section of the first metal layer in the thickness direction of the first metal layer by Auger electron spectroscopy, and
in the first condition, α is a maximum value of the concentration of oxygen atoms among the variations in the concentration.

### (Technology 7)

The thermoelectric conversion element according to Technology 6, wherein the variations in the concentration satisfy a second condition of α ≤ 50%.

### (Technology 8)

The thermoelectric conversion element according to any one of Technologies 1 to 7, wherein the thermoelectric conversion material has a La₂O₃-type crystal structure.

### (Technology 9)

The thermoelectric conversion element according to any one of Technologies 1 to 8, wherein the thermoelectric conversion material further comprises Te.

### (Technology 10)

The thermoelectric conversion element according to any one of Technologies 1 to 9, wherein the thermoelectric conversion material has a composition represented by Mg₃₊ₘRₐT_{b}Sb_{2-e-c}Bi_{c}Zₑ, where
the element R is at least one element selected from the group consisting of Ca, Sr, Ba, and Yb,
the element T is at least one element selected from the group consisting of Mn and Zn,
the element Z is at least one element selected from the group consisting of Te, Se, Sc, Y, and La,
a value of m satisfies -0.39 ≤ m ≤ 0.42,
a value of a satisfies 0 ≤ a ≤ 0.12,
a value of b satisfies 0 ≤ b ≤ 0.48,
a value of c satisfies 0 ≤ c ≤ 1.6, and
a value of e satisfies 0.001 ≤ e ≤ 0.06.

### (Technology 11)

A thermoelectric conversion module comprising:
a P-type thermoelectric conversion element;
an N-type thermoelectric conversion element; and
an electrode electrically connecting a first end portion of the P-type thermoelectric conversion element to a first end portion of the N-type thermoelectric conversion element, wherein
the N-type thermoelectric conversion element is the thermoelectric conversion element according to any one of Technologies 1 to 10.

### (Technology 12)

A thermoelectric conversion system comprising:
the thermoelectric conversion module according to Technology 11; and
a heat source disposed adjacent to the electrode.

### (Technology 13)

A method for generating electrical power, the method comprising generating electrical power by creating a temperature difference in the thermoelectric conversion module according to Technology 11 by using heat from a heat source.

### (Technology 14)

A method for manufacturing a thermoelectric conversion element, the method comprising performing a specific treatment on a stack of layers to provide the thermoelectric conversion element, the stack of layers comprising a precursor of a thermoelectric conversion layer and a precursor of a metal layer formed in contact with the precursor of the thermoelectric conversion layer, the specific treatment comprising heating the stack of layers, wherein,
in the thermoelectric conversion element,
the thermoelectric conversion layer comprises a thermoelectric conversion material comprising Mg,
the metal layer comprises a first region and a second region, the first region being disposed within an interior of the metal layer and comprising oxygen atoms, the second region being different from the first region, and
an atomic content of the oxygen atoms in the first region is higher than an atomic content of oxygen atoms in the second region of the metal layer and is higher than an atomic content of oxygen atoms in the thermoelectric conversion layer.

### EXAMPLES

The present disclosure will now be described in detail with reference to Examples. Note that the thermoelectric conversion elements of the present disclosure are not limited to the Examples described below.

### (Working example 1)

Approximately 1.3 g of a powder of an alloy produced by a solid-state reaction and had a composition of Mg_{3.2}Sb_{1.5}Bi_{0.49}Te_{0.01} was weighed in a glove box. An argon atmosphere was maintained in the glove box until a thermoelectric conversion material was obtained. Next, the weighed powder was compacted into a sintering space in a carbon die and compressed with a carbon punch. The die had an inside diameter of 10 mm. Next, the die was placed in a chamber of a spark plasma sintering apparatus. An argon atmosphere was maintained in the chamber. Next, a current was applied to the die with the sintering apparatus while a pressure of 50 MPa was applied to the compact in the die. As a result of the application of the current, the temperature of the die reached 840°C, which was a sintering temperature, and subsequently, the temperature was maintained for 10 minutes. Subsequently, the heating of the die was discontinued by decreasing the current flowing through the die. After a decrease in the die temperature to room temperature was observed, the sintered body was ejected from the die to provide a thermoelectric conversion material of the working example 1. A surface of the ejected thermoelectric conversion material, which was the sintered body, was polished and subsequently washed with acetone, the surface having been a surface that was in contact with the interior surface of the die. The sintered body of the working example 1 had a thickness of approximately 3 mm.

A surface roughness of both end surfaces of the sintered body in a thickness direction thereof was adjusted, and subsequently, Cu electroplating was performed on both the end surfaces of the sintered body to form plated layers. The plating liquid used was a commercially available plating liquid, and the plating was performed under conditions that were recommended for the plating liquid. After completion of the plating, the sintered bodies were washed.

The sintered bodies on which the plated layers had been formed were processed into a rectangular parallelepiped shape with a wire saw. Consequently, the sintered bodies had a square shape contour with a side length of approximately 3 mm in a plane parallel to the plated layers. In addition, a distance between the plated layers was approximately 2.9 mm.

Next, the pair of plated layers formed on both end surfaces of the sintered bodies were connected to external electrodes, and the specific treatment was performed. The specific treatment was as follows. A flow of current was produced between the pair of plated layers in a state in which a heater block that had been heated to 100°C was in contact with one of the plated layers. In addition, a flow of current was produced between the pair of plated layers in a state in which a heater block that had been heated to 100°C was in contact with the other of the plated layers. In this manner, a thermoelectric conversion element of the working example 1 was prepared. The thermoelectric conversion element of the working example 1 included a thermoelectric conversion layer derived from a sintered body and included metal layers derived from plated layers. The specific treatment was performed until |ΔR/(R(t)Δt)| reached less than or equal to 1%/100 hours. ΔR is an amount of change in the electrical resistance of the element over a period from a time t to a time t+Δt. R(t) is the electrical resistance of the element at the time t.

Fig. 8 is a photograph showing the thermoelectric conversion element of the working example 1. In Fig. 8, M1 represents a thermoelectric conversion layer, and M2 represents a metal layer.

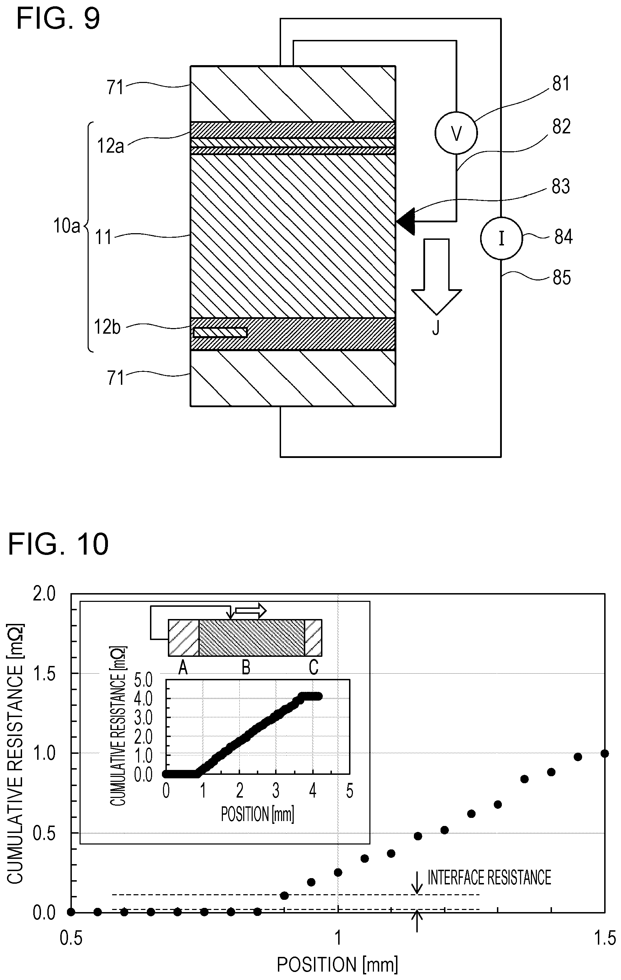

The interface resistivity at the interface between the thermoelectric conversion layer and the metal layer in the thermoelectric conversion element of the working example 1 was determined as follows. Fig. 9 is a schematic diagram illustrating a manner of measuring the electrical resistance of a thermoelectric conversion element. As illustrated in Fig. 9, a pair of external electrodes 71 are attached to a thermoelectric conversion element 10a. An ammeter 84 is electrically connected to both of the pair of electrodes 71 with a lead 85. A voltmeter 81 is connected to one of the external electrodes 71 with a lead 82, and a probe 83 is connected to an end portion of the lead 82, the end portion being located opposite to the one of the external electrodes 71. The electrical resistance was measured with a four-terminal method, while the probe 83 was moved 50 µm each time from the one of the external electrodes 71 to the other of the external electrodes 71 in a direction indicated by an arrow J. The measurement of the electrical resistance was carried out with a source meter (model number: 2400) manufactured by Keithley Instruments, Inc. Fig. 10 is a graph showing exemplary results of measuring the electrical resistance of the thermoelectric conversion element of the working example 1. In Fig. 10, "A" is a portion corresponding to the first metal layer 12a and the one of the external electrodes 71. "B" is a portion corresponding to the thermoelectric conversion layer 11. "C" is a portion corresponding to the second metal layer 12b and the other of the external electrodes 71. The amount of change in the electrical resistance at the boundary between A and B corresponds to the interface resistance at the interface between the thermoelectric conversion layer and the first metal layer. The interface resistivity at the interface between the thermoelectric conversion layer and the metal layer in the thermoelectric conversion element of the working example 1 was determined from the interface resistance mentioned above and an area of a cross section of the thermoelectric conversion element of the working example 1, the cross section being parallel to the metal layer. The result was that the interface resistivity was 1.92 mΩmm².

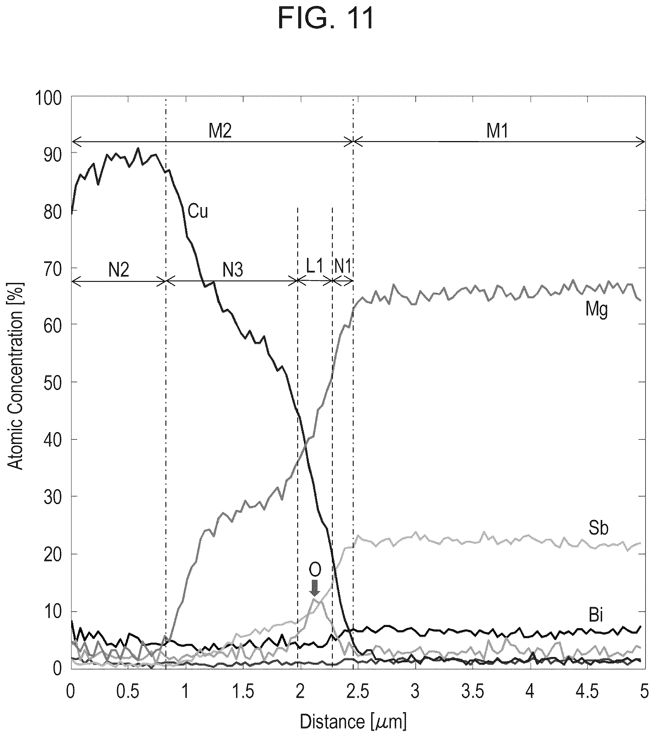

Next, reverse sputtering was performed with Ar ions on a side surface of the thermoelectric conversion element of the working example 1. Accordingly, a sample having a clean surface on which C and O had substantially disappeared was prepared. The time that it took to carry out the reverse sputtering to obtain the clean surface was approximately 1 minute. While the condition of the clean surface was maintained, the sample was transferred to a scanning Auger electron spectrometer PHI 4800, manufactured by Ulvac-PHI, Inc., and a composition line analysis was performed on a region at or near the interface between the thermoelectric conversion layer and the metal layer (first metal layer). Accordingly, an atomic concentration profile of each of the atoms was obtained. The results are shown in Fig. 11. In Fig. 11, M1 represents a range of a distance corresponding to the thermoelectric conversion layer, and M2 represents a range of a distance corresponding to the metal layer (first metal layer). From Fig. 11, it is seen that the thermoelectric conversion layer containing Mg, Sb, and Bi was joined to the metal layer containing Cu and that a concentration peak associated with O was observed within the interior of the metal layer containing Cu and indicated the presence of a portion containing oxygen. In the composition line analysis by AES, a full width at half maximum of the peak of the concentration of oxygen atoms was, for example, 0.3 µm and was in a range of 0.05 µm to 3.0 µm for locations on which the composition line analysis was performed. In addition, in the composition line analysis by AES, the maximum value of the concentration of oxygen atoms was, for example, 10% and was in a range of 0.5% to 35% for locations on which the composition line analysis was performed. The region of N2, which corresponds to a surface layer portion of the metal layer (first metal layer), had a high concentration of Cu.

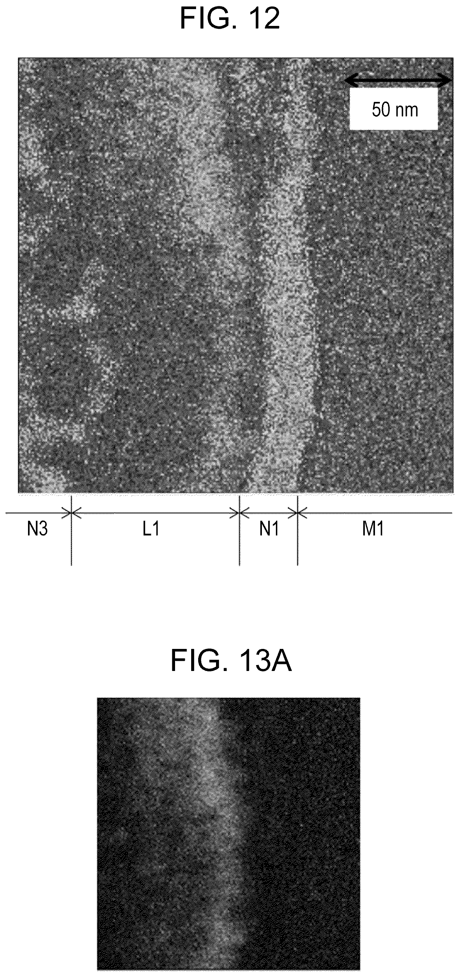

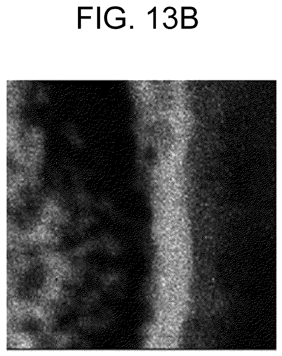

Next, a sample suitable for scanning transmission electron microscope and energy dispersive X-ray spectroscopy (EDX) was prepared by processing a structure located at or near the region observed by AES into a predetermined shape by using a focused ion beam method. Elemental analysis was performed on the prepared sample with a scanning transmission electron microscope and EDX. The scanning transmission electron microscope used was an atomic resolution analytical electron microscope JEM-ARM200F, manufactured by Jeol Ltd. The EDX was performed with an energy dispersive X-ray spectrometry system NORAN System 7 312E, manufactured by Thermo Fisher Scientific Inc. Fig. 12 is a micrograph of a cross section of the thermoelectric conversion element of the working example 1, the micrograph being obtained by scanning transmission electron microscope and energy dispersive X-ray spectroscopy. Fig. 13A is a diagram illustrating a distribution of oxygen atoms in the field of view of the micrograph shown in Fig. 12. Fig. 13B is a diagram illustrating a distribution of copper atoms in the field of the view of the micrograph shown in Fig. 12. In Fig. 12, a portion containing Mg and being in the form of a layer and a portion containing Cu and being in the form of a layer were observed in a region denoted as N1 and a region denoted as N3. The region of N1 had a relatively high Mg concentration, and the region of N3 had a relatively high Cu concentration. The present inventors believed that the specific treatment caused the diffusion of Cu derived from the plating layer and Mg derived from the sintered body, which resulted in the production of this thermoelectric conversion element.

### (Working examples 2 to 12)

Thermoelectric conversion elements of the working examples 2 to 12 were prepared in the same manner as in the working example 1, except that powders of alloys each having the composition shown in Table 1 were used. The thermoelectric conversion elements of the working examples 2 to 12 were evaluated in the same manner as the thermoelectric conversion element of the working example 1. The interface resistivity at the interface between the thermoelectric conversion layer and the metal layer in the thermoelectric conversion element of each of the working examples 2 to 12 is shown in Table 1. From the results of the evaluation of the interface between the thermoelectric conversion layer and the metal layer, the present inventors found that a portion containing oxygen was present within the interior of the metal layer (first metal layer).

### (Comparative example 1)

A thermoelectric conversion element of the comparative example 1 was prepared in the same manner as in the working example 1, except that the specific treatment was not performed.

The thermoelectric conversion element of the comparative example 1 was evaluated in the same manner as the thermoelectric conversion element of the working example 1. The interface resistivity at the interface between the thermoelectric conversion layer and the metal layer in the thermoelectric conversion element of the comparative example 1 is shown in Table 1. From the results of the evaluation of the interface between the thermoelectric conversion layer and the metal layer, the present inventors found that, at the interface between the thermoelectric conversion layer and the metal layer, the thermoelectric conversion layer was in direct contact with a portion containing oxygen.

### (Comparative example 2)

A thermoelectric conversion element of the comparative example 2 was prepared in the same manner as in the comparative example 1, except that the powder of an alloy used was a powder of an alloy having a composition of Mg_{3.2}Sb_{1.0}Bi_{0.99}Te_{0.01}. The thermoelectric conversion element of the comparative example 2 was evaluated in the same manner as the thermoelectric conversion element of the working example 1. The interface resistivity at the interface between the thermoelectric conversion layer and the metal layer in the thermoelectric conversion element of the comparative example 2 is shown in Table 1. In the comparative example 2, as with the comparative example 1, the present inventors found that, at the interface between the thermoelectric conversion layer and the metal layer, the thermoelectric conversion layer was in direct contact with a portion containing oxygen.

As shown in Table 1, the interface resistivities at the interface between the thermoelectric conversion layer and the metal layer in the thermoelectric conversion elements of the working examples were lower than the interface resistivities at the interface between the thermoelectric conversion layer and the metal layer in the thermoelectric conversion elements of the comparative examples 1 and 2. It was suggested that in the instance where the region containing oxygen atoms is present within the interior of the metal layer, the interface resistivity at the interface between the thermoelectric conversion layer and the metal layer is decreased, which is advantageous in terms of decreasing the electrical resistance of thermoelectric conversion elements.

**[Table 1]**

| | Composition of Powder of Alloy | Interface Resistivity [mΩmm²] |
|---|---|---|
| Working example 1 | Mg_{3.2}Sb_{1.5}Bi_{0.49}Te_{0.01} | 1.92 |
| Working example 2 | Mg_{3.1} Sb_{1.5}Bi_{0.49}Te_{0.01} | 2.06 |
| Working example 3 | Mg_{3.05}Sb_{1.5}Bi_{0.49}Te_{0.01} | 2.11 |
| Working example 4 | Mg_{3.2}Sb_{1.0}Bi_{0.99}Te_{0.01} | 2.78 |
| Working example 5 | Mg_{3.1}Sb_{1.0}Bi_{0.99}Te_{0.01} | 2.03 |
| Working example 6 | Mg_{3.05}Sb_{1.0}Bi_{0.99}Te_{0.01} | 2.69 |
| Working example 7 | Mg_{3.2}Sb_{1.5}Bi_{0.49}Te_{0.01}Mn_{0.01} | 2.06 |
| Working example 8 | Mg_{3.2}Sb_{1.5}Bi_{0.49}Te_{0.01}Zn_{0.01} | 1.81 |
| Working example 9 | Mg_{3.2}Sb_{1.0}Bi_{0.99}Te_{0.01}Mn_{0.01} | 2.79 |
| Working example 10 | Mg_{3.2}Sb_{1.0}Bi_{0.99}Te_{0.01}Zn_{0.01} | 2.43 |
| Working example 11 | Mg_{3.2}Yb_{0.06}Sb_{1.0}Bi_{0.99}Te_{0.01} | 2.48 |
| Working example 12 | Mg_{3.2}Sb_{0.5}Bi_{1.49}Te_{0.01} | 2.99 |
| Comparative example 1 | Mg_{3.2}Sb_{1.5}Bi_{0.49}Te_{0.01} | 3.71 |
| Comparative example 2 | Mg_{3.2}Sb_{1.0}Bi_{0.99}Te_{0.01} | 3.58 |

The thermoelectric conversion elements of the present disclosure can be used in a variety of applications, including applications of thermoelectric conversion elements of the related art.

### Reference Signs List

10a, 10b thermoelectric conversion element
11 thermoelectric conversion layer
12a first metal layer
12b second metal layer
12j first region
12p first electrode layer
12q first intermediate layer
12r second intermediate layer
20a P-type thermoelectric conversion element
31 electrode
70 heat source
100, 200, 300, 400 thermoelectric conversion module
500 thermoelectric conversion system

## Claims

1. A thermoelectric conversion element comprising:
a first metal layer;
a second metal layer; and
a thermoelectric conversion layer that is disposed between the first metal layer and the second metal layer in a thickness direction of the first metal layer and comprises a thermoelectric conversion material comprising Mg, wherein
the first metal layer comprises a first region and a second region, the first region being disposed within an interior of the first metal layer and comprising oxygen atoms, the second region being different from the first region, and
an atomic content of the oxygen atoms in the first region is higher than an atomic content of oxygen atoms in the second region of the first metal layer and is higher than an atomic content of oxygen atoms in the thermoelectric conversion layer.

2. The thermoelectric conversion element according to claim 1, wherein the thermoelectric conversion material further comprises at least one selected from the group consisting of Sb and Bi.

3. The thermoelectric conversion element according to claim 1, wherein the first region further comprises Mg.

4. The thermoelectric conversion element according to claim 1, wherein
the first metal layer further comprises a first electrode layer and a first intermediate layer, the first electrode layer comprising Cu, the first intermediate layer being disposed between the first electrode layer and the thermoelectric conversion layer in the thickness direction of the first metal layer and comprising Mg and Cu, and
the first region is present between the first intermediate layer and the first electrode layer in the thickness direction of the first metal layer.

5. The thermoelectric conversion element according to claim 4, wherein
the first metal layer further comprises a second intermediate layer disposed between the first electrode layer and the first intermediate layer in the thickness direction of the first metal layer and comprising Mg and Cu, and
the first region is present between the first intermediate layer and the second intermediate layer in the thickness direction of the first metal layer.

6. The thermoelectric conversion element according to claim 1, wherein
variations in an atomic concentration of oxygen atoms in the thickness direction of the first metal layer satisfy a first condition expressed as 0.5% ≤ α, at a position corresponding to the first region,
the variations in the concentration are obtained through a composition line analysis performed on a cross section of the first metal layer in the thickness direction of the first metal layer by Auger electron spectroscopy, and
in the first condition, α is a maximum value of the concentration of oxygen atoms among the variations in the concentration.

7. The thermoelectric conversion element according to claim 6, wherein the variations in the concentration satisfy a second condition of α ≤ 50%.

8. The thermoelectric conversion element according to claim 1, wherein the thermoelectric conversion material has a La₂O₃-type crystal structure.

9. The thermoelectric conversion element according to claim 1, wherein the thermoelectric conversion material further comprises Te.

10. The thermoelectric conversion element according to claim 1, wherein the thermoelectric conversion material has a composition represented by Mg₃₊ₘRₐT_{b}Sb_{2-e-c}Bi_{c}Zₑ, where
the element R is at least one element selected from the group consisting of Ca, Sr, Ba, and Yb,
the element T is at least one element selected from the group consisting of Mn and Zn,
the element Z is at least one element selected from the group consisting of Te, Se, Sc, Y, and La,
a value of m satisfies -0.39 ≤ m ≤ 0.42,
a value of a satisfies 0 ≤ a ≤ 0.12,
a value of b satisfies 0 ≤ b ≤ 0.48,
a value of c satisfies 0 ≤ c ≤ 1.6, and
a value of e satisfies 0.001 ≤ e ≤ 0.06.

11. A thermoelectric conversion module comprising:
a P-type thermoelectric conversion element;
an N-type thermoelectric conversion element; and
an electrode electrically connecting a first end portion of the P-type thermoelectric conversion element to a first end portion of the N-type thermoelectric conversion element, wherein
the N-type thermoelectric conversion element is the thermoelectric conversion element according to claim 1.

12. A thermoelectric conversion system comprising:
the thermoelectric conversion module according to claim 11; and
a heat source disposed adjacent to the electrode.

13. A method for generating electrical power, the method comprising generating electrical power by applying a temperature difference to the thermoelectric conversion module according to claim 11 by using heat from a heat source.

14. A method for manufacturing a thermoelectric conversion element, the method comprising performing a specific treatment on a stack of layers to provide the thermoelectric conversion element, the stack of layers comprising a precursor of a thermoelectric conversion layer and a precursor of a metal layer formed in contact with the precursor of the thermoelectric conversion layer, the specific treatment comprising heating the stack of layers, wherein,
in the thermoelectric conversion element,
the thermoelectric conversion layer comprises a thermoelectric conversion material comprising Mg,
the metal layer comprises a first region and a second region, the first region being disposed within an interior of the metal layer and comprising oxygen atoms, the second region being different from the first region, and
an atomic content of the oxygen atoms in the first region is higher than an atomic content of oxygen atoms in the second region of the metal layer and is higher than an atomic content of oxygen atoms in the thermoelectric conversion layer.
